# FASCICULE DE BREVET EUROPEEN

(11) **EP 2 885 816 B1**
(45) Date de publication et mention de la délivrance du brevet: **10.03.2021**
(21) Numéro de dépôt: 13748019.0
(22) Date de dépôt: 12.08.2013
(51) Int. Cl.: H01L 27/146, H01L 25/16

(54) **COMPOSANT SEMICONDUCTEUR ET PROCEDE DE FABRICATION D'UN COMPOSANT SEMICONDUCTEUR**
HALBLEITERBAUELEMENT UND VERFAHREN ZUR HERSTELLUNG EINES HALBLEITERBAUELEMENTS
SEMICONDUCTOR COMPONENT AND PROCESS FOR FABRICATING A SEMICONDUCTOR COMPONENT

(30) Priorité: 14.08.2012 FR 1257810
(43) Date de publication de la demande: 24.06.2015
(73) Titulaire: Commissariat à l'Énergie Atomique et aux Énergies Alternatives, 75015 Paris (FR)
(72) Inventeur: BOULARD, François, 38000 Grenoble (FR); GRAVRAND, Olivier, 38120 Fontanil Cornillon (FR)
(74) Mandataire: Brevalex
(86) Numéro de dépôt international: PCT/EP2013/066779
(87) Numéro de publication internationale: WO 2014/026941

(56) Documents cités:
- EP-A1- 1 280 207
- WO-A1-2008/043786
- WO-A1-2010/074288
- US-A- 5 376 558
- US-A- 6 005 276

## Description

### DOMAINE TECHNIQUE

L'invention se rapporte au domaine de l'optoélectronique et des composants semiconducteurs optoélectroniques.

Que cela concerne l'émission de lumière ou la mesure de lumière, les composants optoélectroniques sont devenus incontournables.

En effet, de tels composants présentent, pour un volume occupé qui est faible, des performances quant à leur rendement émissif, pour les composants émettant de la lumière, ou quant à leur sensibilité pour les composants capteurs de lumière, difficilement accessibles avec les technologies autres que celles de l'optoélectronique.

L'amélioration des rendements émissifs et du rapport signal sur bruit reste néanmoins une problématique constante de la micro-électronique.

L'invention se rapporte plus précisément à un composant semiconducteur et à un procédé de fabrication d'un tel composant.

### ÉTAT DE LA TECHNIQUE ANTÉRIEURE

Parmi les composants optoélectroniques certains, comme les matrices de capteurs optoélectroniques ou de diodes électroluminescentes formant écrans, comportent un agencement d'une pluralité de structures optoélectroniques fonctionnant en parallèle et indépendamment les unes des autres.

Dans de tels composants, chacune des structures étant une structure de type dipôle aménagée dans un support semiconducteur, il est nécessaire de prévoir un réseau de polarisation adapté pour polariser individuellement chacune des structures. Un tel réseau comporte ainsi un premier moyen de polarisation adapté pour polariser le premier pôle de chacune des structures et des deuxièmes moyens de polarisation adaptés chacun pour polariser, par rapport à la tension de polarisation fournie par le premier moyen de polarisation, le deuxième pôle de l'une des structures.

Afin de simplifier à la fois les étapes de fabrication des structures et le réseau permettant la polarisation individuelle de chacune des structures, il est connu d'aménager les structures dans une couche semiconductrice d'un premier type de conductivité formant une première zone commune à chacune des structures, la formation d'une zone d'un deuxième type de conductivité opposé au premier type de conductivité permettant la formation de chacune des structures. Avec une telle configuration, la couche semiconductrice forme le premier pôle de chacune des structures tandis que chaque zone semiconductrice forme le deuxième pôle de la structure à laquelle elle est associée. Ainsi, la première zone de chacune des structures étant commune, il suffit d'un seul contact pour polariser le premier pôle de l'ensemble des structures, le deuxième pôle de chacune des structures étant polarisé individuellement.

Néanmoins, une telle possibilité nécessite que la couche semiconductrice soit suffisamment conductrice afin d'assurer que la polarisation des premiers pôles de chacune des structures soit homogène. Ainsi une telle configuration n'est pas compatible avec certains semiconducteurs, tels que les semiconducteurs à faible énergie de bande interdite, qui n'autorisent pas de haut niveau de dopage pour au moins un type de conduction. On peut ainsi citer par exemple les tellurures de mercure-cadmium CdₓHg₁₋ₓTe pour lesquels il est difficile une conductivité dont les porteurs majoritaires sont de type trou.

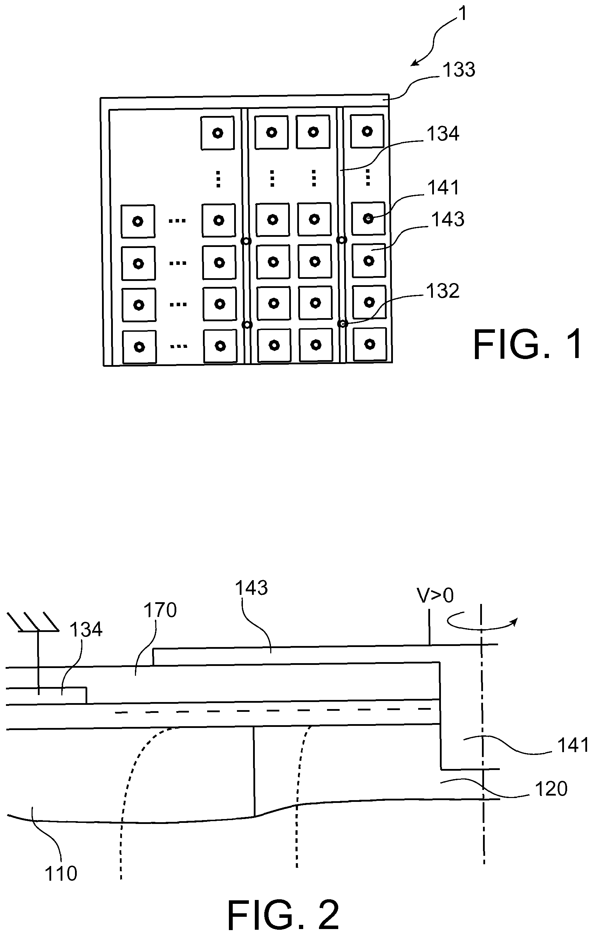

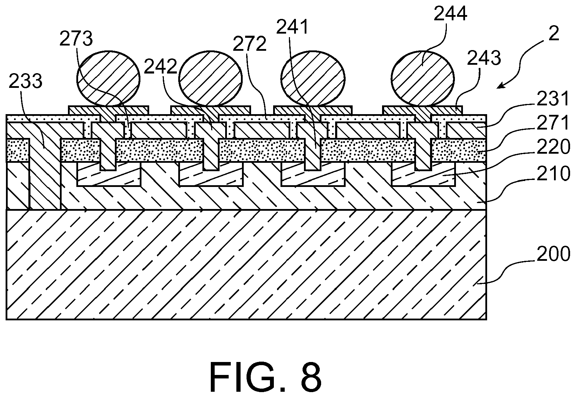

Afin de pallier ce problème il est connu d'équiper les composants avec un réseau de polarisation tel qu'illustré sur la figure 1. Un exemple d'un tel réseau est illustré en figure 8.11, page 297, de l'ouvrage « Handbook of Infrared Detection Technologies » de M. Henini et M. Razeghi. Un composant 1 présentant un tel réseau de polarisation comporte :
- une couche semiconductrice, non représentée, d'un premier type de conductivité dans laquelle sont aménagées les zones semiconductrices, non représentées, d'un deuxième type de conductivité inverse du premier type de conductivité, les zones étant réparties sur une portion de la couche semiconductrice,
- un contact de polarisation périphérique 133 adapté pour polariser la portion de couche semiconductrice sur sa périphérie,
- des pistes conductrices 134 disposées le long de la portion de couche semiconductrice, lesdites pistes étant en contact électrique avec le contact de polarisation périphérique 133,

- des contacts rapprochés 132 disposés le long des pistes conductrices 134 et adaptés pour polariser la portion de la couche semiconductrice en plusieurs emplacements,
- des plots 143 de connexion chacun associé à la zone semiconductrice de l'une des structures, chacun des plots 143 étant en contact électrique avec la zone à laquelle il est associé par un via conducteur 141.

Ainsi le contact de polarisation, les pistes conductrices et les contacts rapprochés forment un premier moyen de polarisation, tandis que chacun des plots de connexion avec le via conducteur correspondant forme un deuxième moyen de polarisation.

Un composant présentant un tel réseau de polarisation permet une polarisation homogène et individuelle de chacune des structures quel que soit le matériau semiconducteur dans lequel est formée la couche semiconductrice.

Néanmoins, si avec une telle configuration du réseau de polarisation la polarisation de la couche semiconductrice est homogène, une telle configuration présente l'inconvénient que chacune des structures est soumise, en fonctionnement, à un environnement électromagnétique différent de celui des autres structures, résultant d'un comportement inhomogène des structures en fonctionnement. En effet, les pistes conductrices, en s'étendant le long de la portion de la couche semiconductrice, font office de grilles et modifient la répartition des charges dans la couche semiconductrice et notamment au niveau des zones semiconductrices. Il en résulte que le fonctionnement des structures s'en trouve affecté.

Le fonctionnement des structures est également affecté, comme cela est illustré sur la figure 2, par une modification de la répartition de la zone de charge d'espace en fonctionnement. En effet, la différence de potentiel entre les plots de connexion 143 et la couche semiconductrice 110 du premier type de conductivité entraîne un chargement de l'isolant 170 qui passive la structure 10 et qui isole les plots de connexion 143 de la surface de la couche semiconductrice 110. Ce chargement de l'isolant 170 modifie, comme illustré sur la figure 2, la répartition de la zone de charge d'espace (en lignes tiretées sur la figure 2) à la surface de la couche semiconductrice 110. Il en résulte au niveau de la surface un « pincement » de la zone de charge d'espace et donc une réduction, au niveau de la surface, de la barrière de potentiel présente entre la couche semiconductrice et chacune des zones semiconductrices 120 ce qui a pour conséquence une augmentation du courant de fuite de chacune des structures.

De plus, dans le cas où les structures sont des structures destinées à recevoir un rayonnement électromagnétique, les plots de contact et les pistes conductrices font également office de réflecteurs pour réfléchir la part du rayonnement électromagnétique reçue par les structures et qui n'est pas absorbée par ces dernières, ceci afin que cette part du rayonnement soit renvoyée dans les structures pour y être absorbée. Avec une telle configuration, les espaces entre les pistes conductrices et les plots de contact ne sont pas couverts par un système de réflecteurs et la part non négligeable du rayonnement qui passe par ces espaces n'est pas renvoyée dans les structures et ne contribue donc pas au signal. Un tel inconvénient est également existant dans le cas où les structures sont des structures destinées à émettre un rayonnement électromagnétique, la part du rayonnement électromagnétique non émise en direction de la face émettrice de la structure devant être réfléchie par les plots de connexion et les pistes conductrices faisant office de réflecteurs.

Les inconvénients d'environnements électromagnétiques différents pour chacune des structures, qui mentionnés ci-dessus, sont associés à l'utilisation des pistes conductrices et sont donc généralement inhérents aux composants comportant une couche semiconductrice qui n'est pas suffisamment conductrice pour assurer une polarisation homogène des premiers pôles de chacune des structures. En ce qui concerne les autres inconvénients mentionnés ci-dessus, c'est-à-dire la présence d'un « pincement » de la zone de charge augmentant le courant de fuite dans chacune des structures et l'existence d'une partie non négligeable du rayonnement non absorbée, ou non émise en direction de la face émettrice, ceux-ci sont également présent dans les composants ne présentant pas une telle couche semiconductrice.

En effet, dans les composants ne comportant pas une telle couche semiconductrice, tels que par exemple les composants comportant une couche semiconductrice réalisée dans un tellurure de mercure-cadmium CdₓHg₁₋ₓTe présentant une conductivité du type dans lequel les porteurs majoritaires sont des électrons , et qui ne comportent donc pas de pistes conductrices, les plots de connexion sont employés pour polariser les zones semiconductrices des structures et pour réfléchir la part du rayonnement électromagnétique qui n'est pas absorbée lors du passage du rayonnement dans les structures, ou qui n'est pas émise en direction de la face émettrice de la structure. Il en résulte que, de même que pour un composant présentant des pistes conductrices, les plots de connexion entraînent un chargement de l'isolant passivant la couche semiconductrice. En raison de ce chargement, de tels composants présentent donc également en fonctionnement un « pincement » des zones de charge d'espace de leurs structures et donc un courant de fuite non négligeable qui s'ajoute aux inconvénients qu'une part significative du rayonnement non absorbée, ou non émise en direction de la face émettrice, par les structures n'est pas réfléchie en raison de l'espacement entre les plots de connexion

Le document EP 1 280 207 A1 divulgue un détecteur comprenant un groupement de photodiodes formées par des zones d'un deuxième type de conductivité amenagées dans une couche semi-conductrice d'un premier type de conductivité. Une couche d'arrêt à canal du premier type de conductivité est formée entre lesdites zones du deuxième type de conductivité adjacentes. La couche d'arrêt à canal présente un motif en forme de grille servant à séparer lesdites zones du deuxième type de conductivité. Un premier moyen de polarisation est connecté à la couche d'arrêt à canal. Des deuxièmes moyens de polarisation sont connectés auxdites zones du deuxième type de conductivité respectivement.

Des documents US 5 376 558 A, WO 2008/043786 A1 et US 6 005 276 A divulguent des détecteurs de rayonnement électromagnétique comprenant des dispositifs de traitement de signaux issus des détecteurs.

### EXPOSÉ DE L'INVENTION

La présente invention vise à remédier au moins en partie aux inconvénients susmentionnés.

Un but de l'invention est de fournir un composant comportant une pluralité de structures semiconductrices aménagées dans une couche semiconductrice, chaque structure présentant en fonctionnement un courant de fuite réduit vis-à-vis d'une structure d'un composant de l'art antérieur.

Un autre but de l'invention est de fournir un composant comportant une pluralité de structures semiconductrices aménagées dans une couche semiconductrice, chacune des structures étant destinées à absorber un rayonnement électromagnétique et étant polarisée au moyen d'un plot de connexion correspondant faisant également office de réflecteur, le composant pouvant être adapté de manière à ce que la part du rayonnement reçue par le composant et non absorbée par les structures est significativement réduite vis-à-vis d'un composant de l'art antérieur.

Un autre but de l'invention est de fournir un composant comportant une pluralité de structures semiconductrices aménagées dans une couche semiconductrice, chacune des structures étant destinées a émettre un rayonnement électromagnétique et étant polarisée au moyen d'un plot de connexion correspondant faisant également office de réflecteur, le composant pouvant être adapté de manière à ce que la part du rayonnement émis par les structure et non transmise en direction de la face émettrice soit significativement réduite par rapport à un composant de l'art antérieur.

Un autre but de l'invention est de fournir un composant comportant une pluralité de structures semiconductrices aménagées dans une couche semiconductrice qui forme les premiers pôles desdites structures, ladite couche semiconductrice n'étant pas suffisamment conductrice pour assurer une polarisation homogène des premiers pôles de chacune des structures, le composant comportant un premier moyen de polarisation de la couche semiconductrice qui est adapté pour que les structures présentent un environnement électromagnétique sensiblement identique entre elles.

A cet effet, l'invention concerne un composant semiconducteur tel que définit dans la revendication 1 comportant :
- un support semiconducteur comportant une première face et au moins une couche semiconductrice, d'un premier type de conductivité, dont la surface forme ladite première face,
- une pluralité de structures semiconductrices optoélectroniques aménagées dans une portion de la couche semiconductrice, chaque structure comportant au moins une zone semiconductrice d'un deuxième type de conductivité opposé au premier type de conductivité,
- une couche électriquement isolante en contact avec la première face du support et s'étendant au moins le long de la portion de couche semiconductrice,
- un premier moyen de polarisation adapté pour polariser la couche semiconductrice le long de la portion de la couche semiconductrice,
- des deuxièmes moyens de polarisation chacun associé à une structure semiconductrice et chacun adapté pour polariser la zone semiconductrice de la structure correspondante,
le premier moyen de polarisation comprenant une couche conductrice en contact avec la couche isolante sur la face de la couche isolante qui est opposée au support et qui s'étend le long de la portion de la couche semiconductrice, la couche conductrice comportant des passages pour chacun des deuxièmes moyens de polarisation avec un espacement entre la couche conductrice et chacun desdits deuxièmes moyens de polarisation qui est situé en regard de la zone semiconductrice correspondante, la couche conductrice recouvrant au moins en partie chacune desdites zones semiconductrices.

Ci-dessus et dans le reste de ce document, on entend par « une couche semiconductrice présentant un premier type de conductivité » que la majeur partie de la couche semiconductrice comporte un premier type de conductivité, cette dernière pouvant, sur certaines zones, tels que les zones semiconductrices associées au structures, présenter un type de conductivité qui est autre.

La couche électriquement isolante est également dite couche isolante.

Une telle couche conductrice entraîne, lorsque les structures sont en fonctionnement, un chargement de la couche isolante. Ce chargement a lieu dans les régions de la couche isolante qui sont à la fois recouvertes par la couche conductrice et qui recouvrent les emplacements de la couche semiconductrice dont le potentiel est modifié par la polarisation de l'une des zones semiconductrices. Ainsi, l'espacement entre la couche semiconductrice et le deuxième moyen de polarisation correspondant étant positionné pour chaque structure en regard de la zone semiconductrice correspondante, le chargement de la couche isolante influence la répartition de la zone de charge d'espace au moins dans sa partie s'étendant au delà de la zone semiconductrice. Ainsi, le chargement engendré par la couche conductrice inhibe toute influence du deuxième moyen de polarisation correspondant évitant l'apparition d'un « pincement » de la zone de charge d'espace tel qu'observé pour les composants de l'art antérieur. Les structures, d'un tel composant, en ne présentant pas un phénomène de pincement de la zone de charge d'espace, offrent, en fonctionnement, un courant de fuite réduit vis-à-vis des structures d'un composant de l'art antérieur.

De plus, avec une telle configuration du composant et pour des structures destinées à absorber un rayonnement électromagnétique, la couche conductrice et les deuxièmes moyens de polarisation peuvent être adaptés pour réfléchir le rayonnement électromagnétique reçu par le composant. Selon cette possibilité, en fonctionnement la part du rayonnement électromagnétique non absorbée par les structures est réfléchie par la couche conductrice et les deuxièmes moyens pour être retransmise aux structures afin qu'elle y soit absorbée et qu'elle contribue au signal. La partie du rayonnement électromagnétique qui n'est pas absorbée est celle passant par les espacements présents entre la couche conductrice et les deuxièmes moyens de polarisation. Ces espacements étant positionnés chacun en regard de la zone semiconductrice correspondante, il en résulte que pour une dimension identique à celle des espacements de l'art antérieur, ils occupent une surface réduite par rapport à ceux des composants de l'art antérieur que ceux-ci présentent ou non des pistes conductrices. Un composant selon cette possibilité présente donc une partie réduite du rayonnement qui n'est pas absorbée vis-à-vis des structures de l'art antérieur. Ceci est également transposable dans le cas où les structures sont destinées à émettre un rayonnement électromagnétique, une partie réduite de rayonnement électromagnétique émis se retrouvant non transmis en direction de la face émettrice du composant.

On peut enfin noter qu'avec un tel composant, la polarisation de la couche semiconductrice peut aisément être obtenue au moyen de contacts rapprochés électriquement reliés à la couche conductrice sans différence d'environnement électromagnétique significatif des structures. En effet, avec un tel composant, l'environnement électromagnétique de chaque structure est principalement lié à la couche conductrice et au plot de contact sans influence d'une quelconque piste conductrice. Chaque structure est donc, pour une polarisation identique de chacune d'entre elles, soumise au même environnement électromagnétique sans influence significative d'un éventuel contact rapproché. Il en résulte une réponse à un rayonnement électromagnétique donné qui est plus homogène pour l'ensemble des structures du composant par rapport aux structures d'un composant de l'art antérieur comportant des pistes conductrices pour contacter les contacts rapprochés.

Au moins une partie, de préférence la totalité des structures sont des structures destinées à absorber un rayonnement électromagnétique et a le transformer en un signal électrique.

La couche conductrice recouvre au moins en partie chacune desdites zones semiconductrices.

La partie de chacune des zones semiconductrices recouverte par la couche conductrice peut comprendre la part de la zone de charge d'espace, formée entre ladite zone semiconductrice et la couche semiconductrice, qui se trouve dans la zone semiconductrice.

La part de la zone de charge d'espace ci-dessus s'entend bien entendu, comme la partie représentant la totalité de la part de la zone de charge d'espace se trouvant dans la zone semiconductrice.

Chacune des zones semiconductrices peut comporter une concentration en porteurs majoritaires au moins 10 fois supérieure à celle de la couche semiconductrice, et la couche conductrice peut recouvrir une partie de chacune des zones semiconductrices qui s'étend à partir de la couche semiconductrice sur une dimension d'au moins 0,1 µm, préférentiellement d'au moins 0,2 µm et de manière particulièrement avantageuse d'au moins 0,5 µm.

Les dimensions du passage de chacun des deuxièmes moyens de polarisation peuvent être adaptées pour qu'une partie de la zone semiconductrice de la structure correspondante soit recouverte par la zone conductrice, le pourtour extérieur de ladite zone semiconductrice étant recouvert par la couche conductrice.

De cette manière, la couche conductrice permet, lorsque les structures sont en fonctionnement, de modifier le chargement de la couche isolante et donc de modifier la répartition de chaque zone de charge d'espace dans la zone semiconductrice correspondante. Il en résulte un élargissement de largeur de la zone de charge d'espace à proximité de la couche isolante et donc de la barrière de potentiel qui y est liée. Le courant de fuite de chacune des structures s'en trouve limité par rapport à une structure de l'art antérieure qui ne présente pas un tel élargissement de la zone de charge d'espace.

Le premier moyen de polarisation est adapté pour polariser la portion de la couche semiconductrice en plusieurs emplacements.

Un tel composant, qu'il comporte ou non une couche semiconductrice suffisamment conductrice afin d'assurer que la polarisation des premiers pôles de chacune des structures est homogène, présente une polarisation des premiers pôles de chacune des structures qui est homogène. En effet, une telle adaptation permet, en polarisant la couche semiconductrice en plusieurs emplacements, de limiter la distance sur laquelle la couche semiconductrice est à même de se dépolariser

Une telle possibilité est particulièrement adaptée dans le cas où la couche semiconductrice n'est pas suffisamment conductrice afin d'assurer que la polarisation des premiers pôles de chacune des structures est homogène.

Bien entendu, le premier moyen peut également être adapté pour polariser la couche semiconductrice en un seul emplacement, comme le pourtour de la portion de la couche semiconductrice.

Cette possibilité est adaptée dans le cas où le composant comporte une couche semiconductrice présentant une bonne conductivité et qui ne présente donc pas une dépolarisation le long de ladite portion.

Les structures étant destinées à fonctionner dans une gamme de longueurs d'onde donnée, la couche conductrice peut être réalisée dans un matériau au moins partiellement réfléchissant dans la gamme de longueurs d'onde donnée,

La couche conductrice peut être réfléchissante dans la gamme de longueurs d'onde donnée.

Une couche conductrice réalisée dans un tel matériau réfléchissant permet au composant de présenter des structures semiconductrices optoélectroniques avec un rendement amélioré. En effet, dans le cas où les structures sont des structures destinées à émettre de la lumière, cette couche conductrice permet de réfléchir en direction du substrat la lumière qui n'aurait pas été émise en direction du substrat assurant que l'ensemble de la lumière émise par la jonction le soit, directement ou après réflexion sur la couche conductrice, en direction du substrat. De même, si les structures sont des structures destinées à capturer un signal électromagnétique, le rayonnement électromagnétique reçu par le substrat et passant par la structure, lorsqu'il n'est pas absorbé lors de son passage dans cette dernière, est réfléchi par la surface conductrice et redirigé vers la structure assurant qu'une partie du rayonnement électromagnétique non absorbé par la structure lors du premier passage l'est lors de ce deuxième passage.

Le premier moyen peut comporter une pluralité de chemins de conduction entre la couche conductrice et la couche semiconductrice, lesdits chemins étant agencés le long de la portion de couche conductrice pour polariser la couche semiconductrice en plusieurs emplacements de la portion de la couche semiconductrice.

De tels chemins de conduction permettent de polariser localement la couche semiconductrice le long de sa portion limitant ainsi les risques de dépolarisation de cette dernière qui peuvent exister lorsque le composant ne présente qu'un contact polarisation périphérique.

Chacun des deuxièmes moyens de polarisation peut comporter un via conducteur passant par le passage correspondant de la couche conductrice et est en contact électrique avec la zone semiconductrice de la structure qui est associée audit deuxième moyen de polarisation, chacun desdits vias conducteurs étant séparé électriquement de la couche conductrice par un espace isolant qui forme l'espacement.

De tels vias conducteurs permettent chacun la polarisation d'une zone semiconductrice d'une structure au travers de la couche semiconductrice.

Chacun des deuxièmes moyens de polarisation peut comporter en outre une zone conductrice dans le même plan que la couche conductrice, ladite zone conductrice étant en contact électrique avec le via conducteur et étant séparée électriquement de la couche conductrice par l'espace isolant.

Ainsi la dimension du passage correspondant audit deuxième moyen correspond alors à l'espace isolant et à la zone conductrice dudit deuxième moyen. Une telle zone conductrice permet, par un agencement adéquat de cette dernière vis-à-vis de la zone semiconductrice de la structure à laquelle la zone conductrice est associée, de contrôler l'environnement électromagnétique en fonctionnement de ladite structure. Ainsi, il est possible, avec un agencement adéquat de cette zone d'augmenter la taille de la zone de charge d'espace de la structure. Le rendement et la fiabilité de la structure s'en trouve amélioré.

Les structures étant destinées à fonctionner dans une gamme de longueurs d'onde donnée, la zone conductrice peut être réalisée dans un matériau au moins partiellement réfléchissant dans la gamme de longueurs d'onde donnée, préférentiellement réfléchissant dans la gamme de longueurs d'onde donnée.

Une telle zone conductrice permet, en réfléchissant le rayonnement électromagnétique qui est émis, dans le cas de structures émettrices de lumière, ou reçu, dans le cas de structures de type capteur de lumière, d'augmenter le rendement de la structure à laquelle elle est associée, de la même façon que la couche conductrice lorsque cette dernière est également réfléchissante.

Chacun des passages de l'un des deuxièmes moyens de polarisation peut être constitué du via conducteur, de la zone conductrice et de l'espace isolant correspondant à ce deuxième moyen de polarisation.

Chacune des structures peut être une photodiode adaptée pour fonctionner dans la gamme de longueurs d'onde de l'infrarouge et préférentiellement dans une gamme de longueurs d'onde sélectionnée dans le groupe comportant la gamme de longueurs d'onde du proche infrarouge, de l'infrarouge moyen et de l'infrarouge lointain.

De telles structures sont particulièrement aptes à bénéficier des améliorations apportées par l'invention, la couche semiconductrice dans laquelle elles sont aménagées étant généralement un semiconducteur petit gap particulièrement touché en absence de contacts locaux par une dépolarisation partielle.

La couche semiconductrice peut être réalisée dans un matériau semiconducteur dont la largeur de bande interdite est inférieure à 1,5 eV, le matériau semiconducteur étant préférentiellement du tellurure de mercure-cadmium du type CdₓHg₁₋ₓTe avec x compris entre 1 et 0.

Un composant comportant une telle couche semiconductrice est particulièrement apte à bénéficier des avantages de l'invention. Surtout lorsque l'utilisation d'un seul contact périphérique n'est pas suffisant mais nécessite une polarisation de la couche semiconductrice en plusieurs emplacements. Ainsi, sans le bénéfice de l'invention, les structures d'un tel composant ne présentent pas un comportement homogène entre elles puisque soumises à des environnements électromagnétiques différents liés à la présence des pistes conductrices.

Le composant peut être adapté pour être couplé avec un dispositif de commande, chacun des deuxièmes moyens de polarisation comportant un plot de connexion adapté pour être connecté à un contact du dispositif de commande, cette connexion étant préférentiellement obtenue par hybridation par billes d'indium.

L'invention concerne également un procédé de fabrication d'un composant semiconducteur comportant les étapes consistant à :
- fournir un support semiconducteur présentant une premier face, ladite première face comprenant au moins une couche semiconductrice d'un premier type de conductivité,
- former une couche électriquement isolante en contact avec la première face du support et s'étendant au moins le long d'une portion de couche semiconductrice,
- aménager une pluralité de zones semiconductrices d'un deuxième type de conductivité opposé au premier type de conductivité dans la couche semiconductrice, ceci de manière à former une pluralité de structures semiconductrices optoélectroniques comportant chacune l'une des zones semiconductrices,
- former dans la couche isolante des percées en communication chacune avec une zone semiconsductrice,
- former une couche conductrice, le matériau conducteur formant la couche conductrice remplissant également lesdites percées,
- former dans la couche conductrice des espaces isolants agencés pour isoler des zones conductrices du reste de la couche conductrice, les dites zones conductrices étant chacune en contact avec une percée de manière à former avec le matériau conducteur emplissant la percée un deuxième moyen de polarisation adapté pour polariser la zone semiconductrice correspondante, le reste de la couche conductrice formant un premier moyen de polarisation adapté pour polariser la couche semiconductrice, chaque zone conductrice formant avec l'espace isolant, qui l'isole électriquement du reste de la couche conductrice, un passage dans le reste de la couche conductrice.

Le reste de la couche conductrice peut recouvrir au moins en partie chacune des zones semiconductrices.

Un tel procédé permet la fourniture d'un composant dont les structures présentent un comportement en fonctionnement qui est sensiblement homogène, puisque leur fonctionnement n'est pas affecté par des environnements électromagnétiques qui seraient différents pour chacune des structures électromagnétiques.

Le procédé de fabrication peut comporter en outre, avant l'étape de formation de la couche conductrice, une étape consistant à former des percées en communication chacune avec un emplacement de la portion de la couche semiconductrice, lesdites percées étant destinée à former lors de l'étape de formation de la couche conductrice et de leur remplissage par le matériau conducteur, des chemins de conduction adaptés pour polariser la couche semiconductrice auxdits emplacement.

Un tel procédé de formation permet la formation d'un composant particulièrement adapté dans le cas où la couche semiconductrice n'est pas suffisamment conductrice pour fournir une polarisation homogène des premiers pôles des structures, la polarisation de la couche semiconductrice pouvant avoir lieu en plusieurs emplacements.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre un exemple de composant de l'art antérieur dans lequel la portion de couche semiconductrice comporte des contacts rapprochés afin d'homogénéifier la polarisation de la couche semiconductrice,
- la figure 2 illustre schématiquement une vue en coupe de la répartition de la zone de charge d'espace d'une structure d'un composant tel qu'illustré sur la figure 1,

- la figure 3 illustre une vue de dessus d'un composant selon un premier mode de réalisation l'invention,
- la figure 4 illustre une vue en coupe transversale d'un composant selon le premier mode de réalisation de l'invention,
- les figures 5 illustrent respectivement, pour la figure du dessus et la figure du dessous, une vue en coupe transversale et une vue de dessus d'une structure aménagée dans un composant selon le premier mode de réalisation de l'invention,
- les figures 6a à 6l illustrent les différentes étapes de fabrication d'un composant selon le premier mode de réalisation de l'invention,
- la figure 7 illustre la répartition du champ électrique dans une structure en fonctionnement d'un composant selon le premier mode de réalisation de l'invention,
- la figure 8 illustre une vue en coupe transversale d'un composant selon un deuxième mode de réalisation de l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

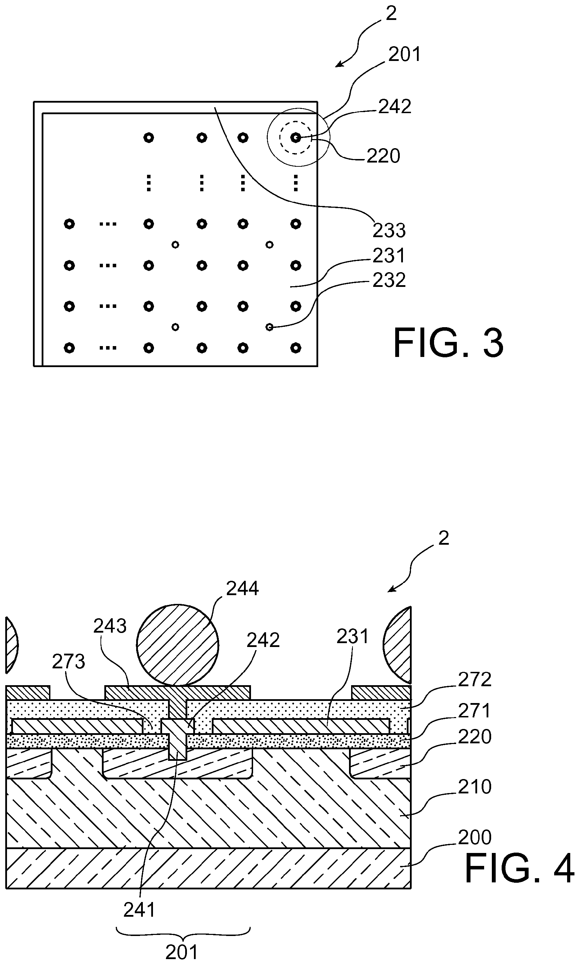

Les figures 3 et 4 illustrent un composant 2 selon l'invention qui comporte une pluralité de structures 201 semiconductrices optoélectroniques.

Le mode de réalisation de l'invention qui est illustré sur les figures 3 à 6, est un mode de réalisation particulier de l'invention dans lequel les structures 201 sont des structures, telles que des photodiodes, adaptées pour capter un rayonnement électromagnétique ceci dans une gamme de longueurs d'onde comprise dans l'infrarouge.

Ce mode de réalisation, appelé application particulière dans la suite de ce document, n'est qu'un exemple d'application de l'invention qui concerne aussi bien les composants comportant des structures semiconductrices optoélectroniques adaptées pour l'émission d'un rayonnement électromagnétique que les composants comportant des structures semiconductrices optoélectroniques de type capteur de rayonnement électromagnétique, lesdites structures étant adaptées pour fonctionner dans une gamme quelconque de longueurs d'onde, telle que les gammes de longueurs d'onde du visible ou du proche infrarouge.

Un composant 2 selon l'invention comporte, comme illustré sur les figures 3 et 4 :
- un support semiconducteur 200, 210 comportant une première face et au moins une couche semiconductrice 210, d'un premier type de conductivité, dont la surface forme ladite première face,
- une pluralité de structures 201 semiconductrices optoélectroniques aménagées dans une portion de la couche semiconductrice 210, chaque structure 201 comportant au moins une zone semiconductrice 220 d'un deuxième type de conductivité opposé au premier type de conductivité,
- une première couche isolante 271 réalisée dans un matériau isolant électriquement électrique et en contact avec la première face du support 200, ladite première couche isolante 271 s'étendant au moins sur la portion de la couche semiconductrice 210,
- un contact périphérique 233 en contact électrique au travers de la première couche isolante 271 avec la couche semiconductrice 210,
- une couche conductrice 231 dans laquelle sont aménagés des passages, ladite couche conductrice 231 présentant en outre des chemins de conduction agencés dans le composant de manière à mettre en contact électrique la couche conductrice 231 et la couche semiconductrice 210 en plusieurs emplacements de la portion de la couche semiconductrice,
- des zones conductrices 242 chacune associées à une structure 201, chaque zone conductrice 242 étant dans le même plan que la couche conductrice 231 et étant électriquement séparée de la couche conductrice 231 par un espace 273,
- des vias conducteurs 241 chacun associé à une structure 201, chaque via conducteur 241 connectant une zone conductrice 242 à zone semiconductrice 220 correspondante,
- une deuxième couche isolante 272 en matériau isolant électriquement électrique qui, étant en contact avec la couche conductrice 231, s'étend le long de la portion de couche semiconductrice 210,
- des plots de connexion 243 disposés sur la deuxième couche isolante 272, chacun étant en contact avec une zone conductrice 242 et étant adapté pour établir un contact électrique, par exemple par hybridation par bille d'indium 244, avec un plot de connexion d'un dispositif de commande (non représenté).

Le support semiconducteur 200, 210 est un support classiquement utilisé pour les applications optoélectroniques, le composant comportant un substrat 200 transparent dans la gamme de longueurs d'onde à laquelle les structures 201 sont destinées à fonctionner. Le substrat 200 est réalisé dans un matériau semiconducteur classiquement utilisé pour les applications de l'optoélectronique, tel que par exemple, le silicium, le carbure de silicium, le saphir.

Le support semiconducteur 200, 210 est un support sensiblement plan.

Dans l'application particulière de l'invention, le substrat semiconducteur 200 est un substrat en tellurure de zinc cadmium (CdZnTe) qui est transparent dans la gamme de longueurs d'onde de l'infrarouge.

La couche semiconductrice 210 est une couche semiconductrice adaptée pour les applications optoélectroniques. La couche semiconductrice 210 est réalisée dans un matériau semiconducteur à gap direct tel que l'arséniure de gallium (GaAs) et le phosphure d'indium (InP). La couche semiconductrice présente sur sa majeure partie un premier type de conductivité sélectionné dans le groupe comportant le type de conductivité dont les porteurs majoritaires sont les électrons et le type de conductivité dont les porteurs majoritaires sont les trous.

On entend par matériau semiconducteur à gap direct un matériau semiconducteur dont le maximum d'énergie de la bande de valence et le minimum d'énergie de la bande de conduction se situent à une valeur du vecteur d'onde k sensiblement dans le diagramme de dispersion énergétique dudit matériau semiconducteur.

Dans l'application particulière, la couche semiconductrice est une couche en tellure mercure-cadmium du type CdₓHg₁₋ₓTe avec X compris entre 0 et 1. La valeur de la proportion en cadmium X est choisie en fonction de la gamme de longueurs d'onde à laquelle les structures sont destinées à fonctionner. Ainsi pour des structures adaptées pour recevoir un rayonnement électromagnétique dans la gamme des infrarouges moyens inférieurs à 3 µm, une proportion en cadmium X peut être égale à 0,4, et pour la gamme des infrarouges moyens inférieurs à 5 µm, la proportion en cadmium X égale à 0,3. Pour des structures 201 adaptées pour recevoir un rayonnement électromagnétique dans la gamme des infrarouges lointains inférieurs à 10 µm, la proportion en cadmium X est égale à 0,22.

Dans l'application particulière, le type de conductivité de la couche semiconductrice 210 est un type de conductivité dont les porteurs majoritaires sont des trous. De même la concentration en porteurs majoritaires de la couche semiconductrice est comprise, dans l'application particulière, entre 10¹⁴ et 10¹⁸ cm⁻³.

La zone semiconductrice 220 de chacune des structures 201 est une zone de la couche semiconductrice 210 dont le type de conductivité est inverse du reste de la couche semiconductrice 220. Ainsi, chaque zone semiconductrice 220 forme, avec la majeure partie de la couche semiconductrice 201, une jonction semiconductrice adaptée pour les applications optoélectroniques.

La conductivité de chacune des zones semiconductrices 220 est, pour une majeure partie de la couche semiconductrice 210 qui est du type de conductivité dont les porteurs majoritaires sont des électrons, du type dont les porteurs majoritaires sont des trous. Pour une majeure partie de la couche semiconductrice 210 dont la conductivité est du type dont les porteurs majoritaires sont des trous, la conductivité des zones semiconductrices 220 est du type dont les porteurs majoritaires sont des électrons.

Chaque zone semiconductrice 220 occupe un volume de la couche semiconductrice 210 en s'étendant préférentiellement à partir de la première face du support semiconducteur. La forme de la zone peut être cubique, parallélépipédique, cylindrique ou autre. Chaque zone semiconductrice 220 peut se prolonger en profondeur à partir de la première face du support sur tout ou partie de l'épaisseur de la couche semiconductrice 210.

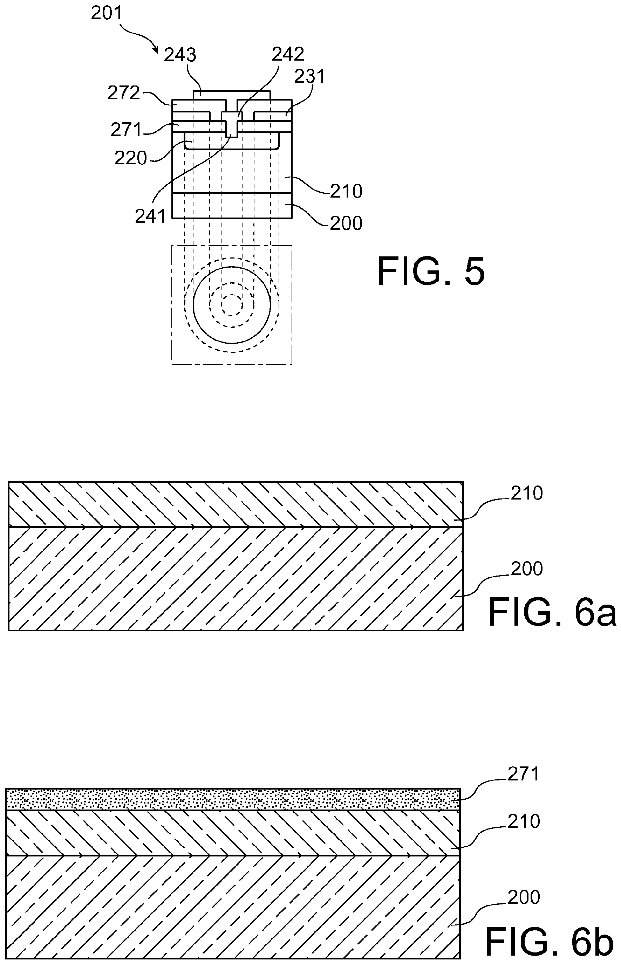

Dans l'application particulière, chacune des zones semiconductrices 220 présente une conductivité du type dont les porteurs majoritaires sont des électrons. Chaque zone semiconductrice 220 présente, comme illustré sur les figures 5, une forme sensiblement cylindrique qui s'étend à partir de la première face sur un quart de l'épaisseur de la couche semiconductrice 210. La concentration en porteurs majoritaires de chaque zone semiconductrice 220 est comprise, dans l'application particulière, entre 10¹⁴ et 10¹⁸ cm⁻³.

Avantageusement, chacune des zones semiconductrices 220 présente une concentration en porteurs majoritaires au moins dix fois supérieure à celle de couche semiconductrice 210.

Chacune des zones semiconductrices 220 et la fraction de la couche semiconductrice 210 avec laquelle ladite zone semiconductrice 220 est en contact, forme une structure 201 optoélectronique qui est adaptée soit à émettre un rayonnement électromagnétique, soit à recevoir un rayonnement électromagnétique. Selon cette configuration chaque fraction de la couche semiconductrice 210 forme le premier pôle de la structure 201 correspondante, la zone semiconductrice 220 correspondante formant le deuxième pôle de cette même structure 201.

Dans l'application particulière, la zone semiconductrice 220 et la fraction de la couche semiconductrice avec laquelle la zone semicondcutrice 220 est en contact forme une structure 201 optoélectronique adaptée pour recevoir un rayonnement électromagnétique, c'est-à-dire du type capteur.

Dans l'application particulière, comme cela est le cas dans la majeure partie des modes de réalisation de l'invention, les structures 201 sont aménagées dans la couche semiconductrice 210 sous la forme d'une matrice de structures 201. Ainsi, les structures 201 organisées en colonnes et en rangées permettent de couvrir la surface d'une portion de la couche semiconductrice 210 de manière ordonnée permettant aisément d'adresser individuellement chacune des structures 201.

La première couche isolante 271 est en contact avec la première face de la couche semiconductrice 210 et s'étend le long de la couche semiconductrice 210 sur la portion de couche semiconductrice 210 dans laquelle sont aménagées les structures 201. Elle est réalisée un matériau isolant électriquement, tel que du dioxyde de silicium SiO₂, du tellurure de cadmium CdTe ou du sulfure de zinc ZnS.

L'épaisseur de la première couche isolante 271 est adaptée pour isoler la couche semiconductrice 210 de la couche conductrice 231.

Dans l'application particulière, le matériau isolant électriquement est choisi dans le groupe comportant le dioxyde de silicium (SiO₂), le tellurure de cadmium (CdTe) et le sulfure de zinc (ZnS), ou tout autre matériau possédant une constante diélectrique élevée, également connu sous la dénomination anglaise High-K.

La couche isolante 271 peut présenter une épaisseur de quelques centaines de nanomètres.

Le contact périphérique 233, les chemins de conduction 232 et les vias conducteurs 241 sont aménagés dans la couche isolante 271. Le contact périphérique 233, et les chemins de conduction 232 sont adaptés pour mettre en communication la couche conductrice 231 avec la majeure partie de la couche semicondutrice 210 respectivement au niveau de la périphérie de la portion de la couche semiconductrice 210 et en des emplacements de la couche semiconductrice 210. Les vias conducteurs 241 sont agencés dans la première couche isolante 271, le long de la couche semiconductrice 210, de manière à connecter chacun une structure 201 à laquelle ils sont associés et une zone conductrice 242 correspondant à ladite stucture semiconductrice 201.

La couche conductrice 231 est en contact avec la première couche isolante 271 sur la face de la première couche isolante 271 qui est opposée à la couche semiconductrice 220. La couche conductrice 231 s'étend sensiblement au niveau de la portion de la couche semiconductrice 220. La couche conductrice 231 est réalisée dans un matériau conducteur. La couche conductrice 231 est préférentiellement réalisée dans un matériau adapté pour réfléchir au moins partiellement un rayonnement électromagnétique dont la longueur d'onde est dans la gamme de longueurs d'onde dans laquelle les structures 201 sont adaptées pour fonctionner. Le matériau conducteur peut être, par exemple, de l'or (Au). La couche conductrice présente préférentiellement une épaisseur de quelques centaines de nanomètres.

Dans l'application particulière la couche conductrice est réalisée en or (Au).

La couche conductrice 231 comporte des passages chacun adapté pour le placement d'une zone conductrice 242 qui est associée à une structure 201 et pour la présence d'un espace isolant 273 entre ladite zone conductrice 242 et la couche conductrice 231. Ainsi, chaque passage est adapté pour le passage de l'un des deuxièmes moyens de polarisation comportant la zone conductrice 231 correspondante.

La couche conductrice 231 forme avec le contact périphérique 233 et les chemins de conduction 232 un premier moyen de polarisation adapté pour polariser la couche semiconductrice 220 en plusieurs emplacements.

Chacune des zones conductrices 242 est une zone en matériau conducteur sensiblement plane qui recouvre le via conducteur 241 correspondant à la structure 201 à laquelle ladite zone conductrice 242 est associée. Chaque zone conductrice 242 s'étend sensiblement sur le même plan que la couche conductrice 231. Chaque zone conductrice 242 est réalisée dans un matériau conducteur. Chaque zone conductrice 242 est préférentiellement réalisée dans un matériau adapté pour réfléchir au moins partiellement un rayonnement électromagnétique dont la longueur d'onde est dans la gamme de longueurs d'onde dans laquelle les structures 201 sont adaptée pour fonctionner. Le matériau conducteur peut être de l'or (Au). La zone conductrice présente préférentiellement une épaisseur de quelques centaines de nanomètres.

La couche conductrice 231 et les zones conductrices 242 sont préférentiellement réalisées dans le même matériau conducteur.

Chaque zone conductrice 242, avec l'espace isolant 273, est dimensionnée de manière à ce que l'espace isolant 273 soit en regard de la zone semiconductrice 220.

Chaque zone conductrice 242, avec l'espace isolant 273, est préférentiellement dimensionnée, comme illustré sur les figures 5, de manière à ce qu'une partie de la zone semiconductrice 220 de la structure 201 correspondante soit recouverte par la couche conductrice 231, le pourtour extérieur de ladite zone semiconductrice 220 étant recouvert par la couche conductrice 231. Avec une telle possibilité, la concentration dans chacune des zones semiconductrices 220 en porteurs de chaque type est influencée en fonctionnement par la polarisation de la couche conductrice 231.

Selon l'invention, la couche conductrice 231 est agencée pour recouvrir une partie de chacune des zones semiconductrices 220 qui comprend la part de la zone de charge d'espace, formée entre ladite zone semiconductrice 220 et la couche semiconductrice 210, qui se trouve dans la zone semiconductrice 220.

Avec des zones semiconductrice comportant une concentration en porteurs majoritaires au moins 10 fois supérieure à celle de la couche semiconductrice, la zone de charge d'espace s'étend principalement dans la couche semiconductrice est s'étend sur une distance inférieure à 0,2 µm voire à 0,1 µm. Ainsi, un tel recouvrement de la zone de charge d'espace formée entre chacune des zones semiconductrice et la couche semiconductrice 210 peut être fournis par une couche conductrice 231 qui recouvre la partie de chacune des zones semiconductrices 220 qui s'étend à partir de la couche semiconductrice 210 sur une dimension d'au moins 0,1 µm, préférentiellement 0,2 µm et de manière particulièrement avantageuse 0,5 µm.

La deuxième couche isolante 272 est en contact avec la couche conductrice 231 sur la face de la couche conductrice 231 qui est opposée à la première couche isolante 271. La deuxième couche isolante 272 s'étend le long de la couche conductrice 231 sensiblement au niveau de la portion de couche semiconductrice 210 dans laquelle sont aménagées les structures 201. La deuxième couche isolante 272 est réalisée dans un matériau isolant électriquement, tel que du dioxyde de silicium (SiO₂), du tellurure de cadmium (CdTe), du sulfure de zinc (ZnS) ou tout autre matériau possédant une constante diélectrique élevée.

Le matériau isolant électriquement dans lequel est réalisée la deuxième couche isolante remplit également l'espace isolant 273.

L'épaisseur de la deuxième couche isolante 272 est adaptée pour isoler la couche conductrice 231 des plots de connexion 243.

Dans l'application particulière, le matériau isolant électriquement formant la deuxième couche isolante est choisi dans le groupe comportant le dioxyde de silicium (SiO₂), le tellurure de cadmium (CdTe) et le sulfure de zinc (ZnS).

Des zones de liaison sont aménagées dans la deuxième couche isolante 272, ces zones de liaison sont agencées pour connecter chacune un plot de connexion 243 avec la zone conductrice 242 correspondant à la structure 201 à laquelle le plot de connexion 243 est associé.

Les plots de connexion 243 sont adaptés pour autoriser une connexion avec un dispositif de contrôle par hybridation par bille d'indium 244. D'autres types d'hybridation sont cependant possibles.

L'ensemble formé par le via conducteur 241, la zone conductrice 242 et le plot de connexion 243 associés à une même structure 201 semiconductrice, forme un deuxième moyen de polarisation de ladite structure 201 adapté pour polariser la zone semiconductrice 220 de ladite structure 201.

Les figures 6a à 6l illustrent les différentes étapes d'un procédé de fabrication d'un composant 2 selon l'invention.

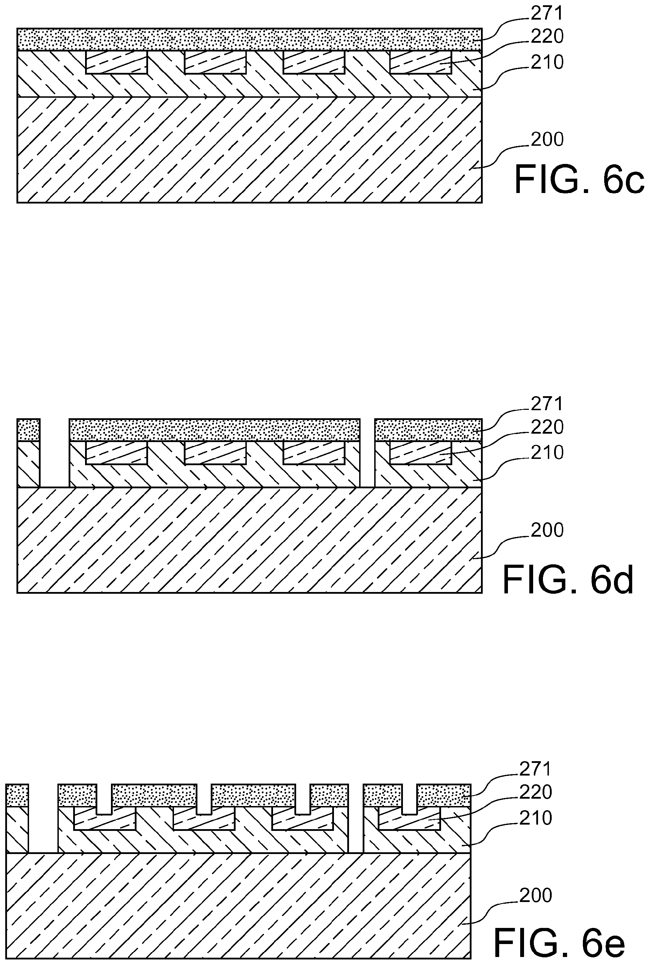

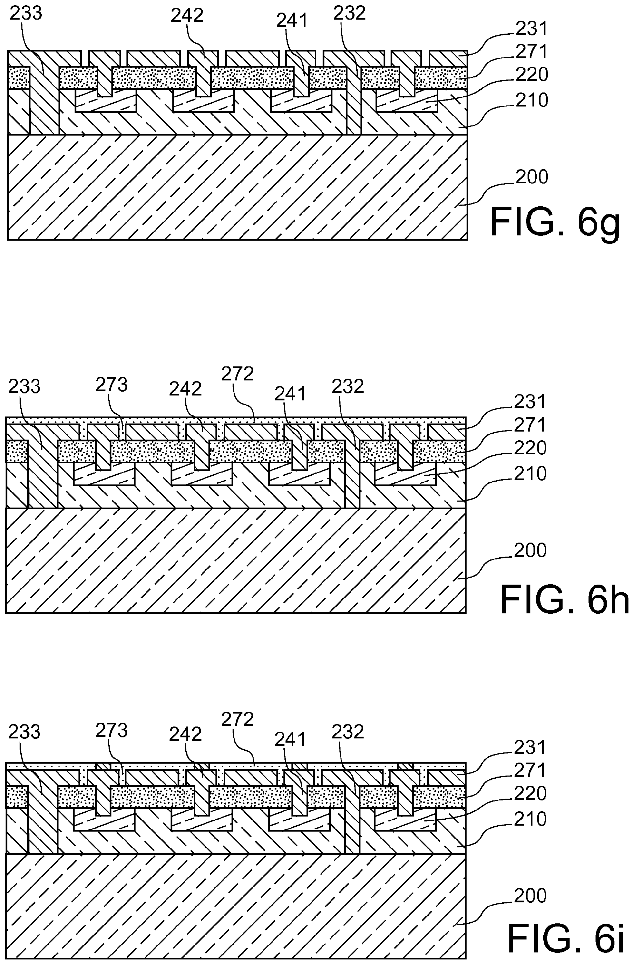

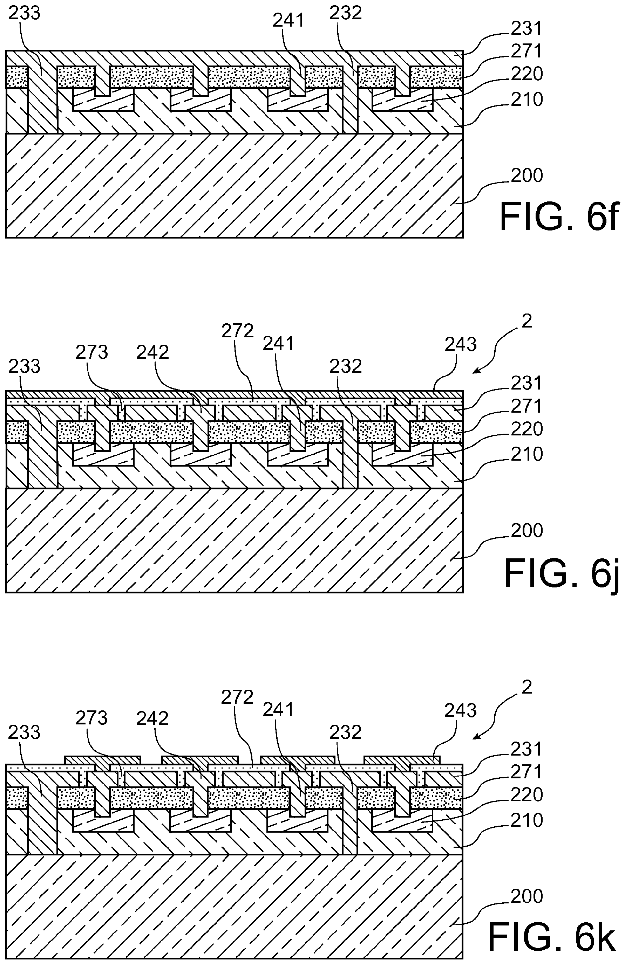

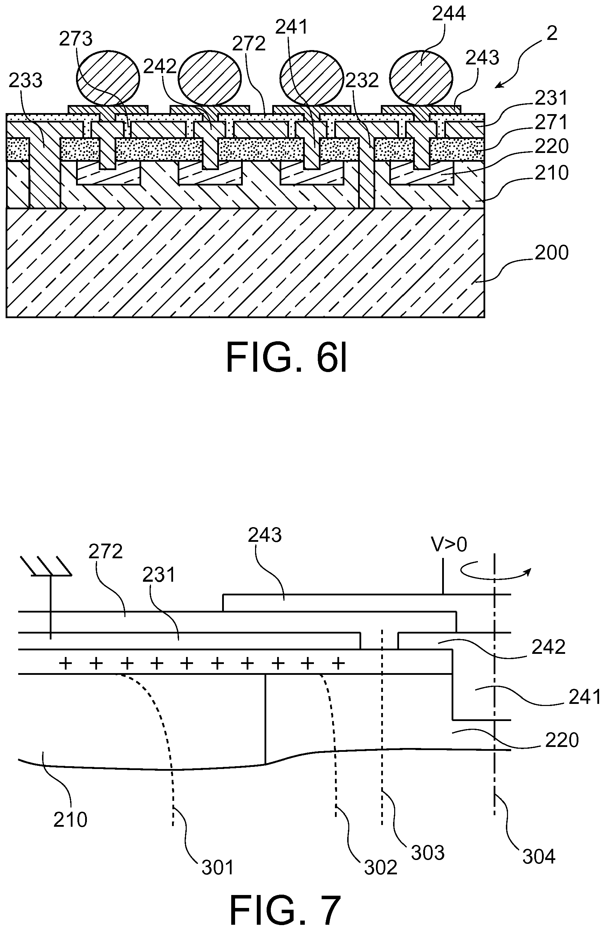

Un tel procédé comprend les étapes consistant à :
- fournir, comme illustré sur la figure 6a, le support présentant une première face, ladite première face comprenant au moins la couche semiconductrice 210 d'un premier type de conductivité,
- former, comme illustré sur la figure 6b, la première couche isolante 271 réalisée dans un matériau isolant électriquement, la première couche isolante 271 étant en contact avec la première face du support et s'étendant au moins le long de la portion de couche semiconductrice 210,
- aménager, comme illustré sur la figure 6c, la pluralité de zones semiconductrices 220 d'un deuxième type de conductivité opposé au premier type de conductivité dans la couche semiconductrice 210, ceci de manière à former une pluralité de structures 201 optoélectroniques comportant chacune l'une des zone semiconductrice 220,
- former, comme illustré sur la figure 6d, dans la première couche isolante 272 des premières percées en communication chacune avec un emplacement de la portion de la couche semiconductrice 210, une partie de ces premières percées étant destinées à former le contact périphérique 233, l'autre partie de ces percées étant destinées à la formation les chemins de conduction 232,
- former, comme illustré sur la figure 6e, dans la première couche isolante 271 des deuxièmes percées en communication chacune avec une zone semiconductrice 220, ces deuxièmes percées étant destinées à la formation des vias conducteurs 241,
- former, comme illustré sur le figure 6f, la couche conductrice 231, le matériau conducteur formant la couche conductrice 231 remplissant également les premières et les deuxièmes percées de manière à former le contact périphérique 233, les chemins de conduction 232 et les vias conducteurs 241,
- former, comme illustré sur la figure 6g, dans la couche conductrice 231 les espaces isolants 273 agencés pour isoler des zones conductrices 242 du reste de la couche conductrice 231, les zones conductrices 242 étant chacune en contact avec un via conducteur 241,
- former, comme illustré sur la figure 6h, la deuxième couche isolante 272 en contact avec la couche conductrice 231, le matériau formant la deuxième couche isolante 272 emplissant les espaces isolants 273 assurant ainsi une meilleure isolation électrique entre les zones conductrices 242 et la couche conductrice 231,
- ménager, comme illustré sur la figure 6i, des zones de liaison dans la deuxième couche isolante 272, les dites zones de liaison formant des ouvertures de la couche isolantes en communication chacune avec une zone conductrice 242,
- déposer, comme illustré sur la figure 6j, une deuxième couche conductrice réalisée dans un matériau conducteur compatible avec l'hybridation par billes d'indium 244, le matériau conducteur emplissant les zones de liaison de manière à connecter électriquement la deuxième couche conductrice avec chacune des zones conductrice 242,
- former, comme illustré sur la figure 6k, les plots de connexion 243 dans la deuxième couche conductrice,
- préparer, comme illustré sur la figure 6l, la connexion du composant ainsi obtenu pour la connexion de ce dernier à un dispositif de commande du composant, ceci en déposant une bille d'indium sur chacun des plots de connexion 244.

Un tel composant fabriqué au moyen d'un tel procédé de fabrication est apte à être relié électriquement à un dispositif de contrôle. Un tel dispositif de contrôle, non illustré, est généralement un composant électronique réalisé dans un support semiconducteur en silicium. Le dispositif est adapté pour contrôler individuellement chacune des structures 201 et traiter les signaux issus de ces structures 201. De tels dispositifs étant connus par ailleurs, ils ne sont pas décrits plus en détail dans ce document.

Le procédé de fabrication décrit ci-dessus est particulièrement adapté pour la fabrication d'un composant selon l'application particulière de l'invention. Bien entendu, l'invention ne se limite pas aux seuls composants susceptibles d'être obtenus par un tel procédé de fabrication mais englobe tous les composants selon l'invention quelque soit le procédé de fabrication qui a permis leur fabrication.

De même certaines étapes peuvent être réalisées simultanément ou dans un ordre différents sans que l'on sorte du cadre de l'invention. Ainsi, par exemple, l'étape d'aménagement des zones semiconductrices 220 dans la couche semiconductrice peut être réalisée préalablement à la formation de la première couche isolante 271, ceci sans que l'on sorte du cadre de l'invention.

L'ensemble des structures 201 semiconductrices selon l'invention présentent, en fonctionnement, un environnement électromagnétique qui est identique. Il en résulte que la répartition des équipotentiels 301, 302, 303, 304 dans chacune des structures est identique assurant un fonctionnement, pour une polarisation donnée, sensiblement identique pour l'ensemble des structures 201 semiconductrices.

La figure 7 illustre un exemple de répartition des équipotentiels 301, 302, 303, 304 le long d'une coupe transversale d'une structure 201 selon l'application particulière de l'invention lorsque cette dernière structure 201 est en fonctionnement. Dans cette configuration, la couche conductrice 231 est mise à la masse tandis que le plot de connexion 243 est polarisé positivement.

La différence de potentiel entre le plot de connexion 244 et la couche conductrice 241 induit une répartition de potentiel le long de la structure 201, telle qu'illustrée sur la figure 7, avec la création d'une zone de charge d'espace présente entre les équipotentiels 301 et 302.

Une telle répartition du potentiel le long de la structure 201, créer dans la deuxième couche isolante 271, en raison de la différence de potentiel entre la couche semiconductrice 210 et la couche conductrice 231, une accumulation de charge. Cette accumulation de charge dans l'isolant modifie à son tour la répartition des équipotentiels 301, 302, 303, 304 dans la couche semiconductrice. Une telle modification, illustrée sur la figure 7, engendre une courbure marquée au niveau de l'équipotentiel 301 et donc un élargissement de la zone de charge d'espace à proximité de la surface de la couche semiconductrice 210.

Avec une configuration selon l'application particulière et avec une concentration en porteurs majoritaires de chacune des zones semiconductrices 220 qui est supérieure au moins 10 fois à celle de la couche semiconductrice 210, la largeurs de la zone de charge d'espace d'une structure est typiquement comprise entre 0,2 à 2 µm avec moins de 10% de la zone de charge d'espace qui s'étend dans la zone semiconductrice 220 correspondante. Avec une couche conductrice 231 recouvrant une partie de la zone semiconductrice 220 s étendant à partir de la couche semiconductrice 210 sur une dimension d'au moins 0,1 µm, voire d'au moins 0,2 µm et préférentiellement 0,5 µm, la couche conductrice recouvre la part de la zone de charge d'espace se trouvant dans la zone semiconductrice 220.

Ainsi, dans cette configuration, la zone de charge d'espace élargie à proximité de la surface de la couche semiconductrice 210, réduit le courant de fuite par effet tunnel qui traverse la structure 201. Avec une telle répartition des équipotentiels 301, 302, 303, 304, une telle structure 201 semiconductrice présente à la fois une sensibilité et une fiabilité accrues.

Un autre avantage de l'invention est le fait que la surface réfléchissante fournie par l'ensemble formé par la couche conductrice 231 et les zones conductrices 242 est, contrairement à l'art antérieur illustré sur la figure 1, faiblement dépendant de la dimension de l'espace isolant disposés entre chaque zone conductrice 242 et la couche conductrice 231. Ainsi, par rapport à une structure de l'art antérieur, lorsque les dimensions de l'espace isolant passent d'une largeur de 500 nm à 2 µm pour une distance entre structure de 30 µm, la surface réfléchissante présente une réduction de seulement 3% contre près de 10% pour un composant de l'art antérieur.

La figure 8 illustre une vue en coupe d'un composant 2 selon un deuxième mode de réalisation. Un tel composant 2 se différencie d'un composant 2 selon le premier mode de réalisation en ce que la portion de la couche semiconductrice 210 n'est polarisée qu'en un seul emplacement 233, le pourtour de la portion de la couche semiconductrice 210, et donc en ce que le composant ne comporte pas de chemin conducteur tel que ceux référencée 232 dans le composant 2 selon le premier mode de réalisation.

Dans ce mode de réalisation la couche semiconductrice 210 est suffisamment conductrice pour polariser chaque premier pôle de chacune des structures 201, et présente donc une concentration ou une mobilité en porteurs majoritaires qui est suffisante pour polariser lesdits premiers pôles de façon homogène.

Un composant 2 selon ce mode de réalisation peut être adapté conformément à l'application particulière décrite dans le premier mode de réalisation. Ainsi, un composant 2 selon l'application particulière du deuxième mode de réalisation se différencie d'un composant 2 selon l'application particulière du premier mode de réalisation en ce que la couche semiconductrice 210 et les zones semiconductrices 220 ont une polarisation inversée, la couche semiconductrice 210 étant donc du type de conductivité dans lequel les porteurs majoritaires sont des électrons et les zones semiconductrices 220 étant donc du type de conductivité dans lequel les porteurs majoritaires sont des trous.

Un procédé de fabrication d'un composant 2 selon le deuxième mode de réalisation se différencie d'un procédé de fabrication d'un composant 2 selon le premier mode de réalisation en ce que l'étape de formation des premières percées consiste à former uniquement une première percée dans la couche isolante en communication avec la portion de la couche semiconductrice 210 qui est destinée à former le contact périphérique 233.

Dans les deux modes de réalisation de l'invention décrit ci-dessus, il est prévu pour chacune des structures une zone conductrice adaptée pour modifier l'environnement électromagnétique de ladite structure. Il est néanmoins envisageable, sans que l'on sorte du cadre de l'invention, que certaines, ou toutes les structures, soient dépourvues d'une telle zone de conduction 242. Selon cette possibilité, le via conducteur 241 de chacune des structures non pourvues d'une zone conductrice, est en contact direct avec la zone de liaison associée à ladite structure. Le via conducteur 241 est dans cette configuration isolé de la couche conductrice 231 par l'espace isolant 273 qui est associé à ladite structure 201.

## Revendications

1. Composant (2) semiconducteur comportant :
- un support semiconducteur (200, 210) comportant une première face et au moins une couche semiconductrice (210), d'un premier type de conductivité, dont la surface forme ladite première face,
- une pluralité de structures (201) semiconductrices optoélectroniques aménagées dans une portion de la couche semiconductrice (210), chaque structure (201) comportant au moins une zone semiconductrice (220) d'un deuxième type de conductivité opposé au premier type de conductivité,
- une couche électriquement isolante (271), en contact avec la première face du support et s'étendant au moins le long de la portion de couche semiconductrice (210),
- un premier moyen de polarisation adapté pour polariser la couche semiconductrice (210) le long de la portion de la couche semiconductrice (210),
- des deuxièmes moyens de polarisation (241, 242) chacun associé à une structure semiconductrice (201) et chacun adapté pour polariser la zone semiconductrice (220) correspondante,
le premier moyen de polarisation comprenant une couche conductrice (231) en contact avec la couche isolante (271) sur la face de la couche isolante (271) qui est opposée au support et qui s'étend le long de la portion de la couche semiconductrice (210), la couche conductrice (231) comportant des passages pour chacun des deuxièmes moyens de polarisation avec un espacement entre la couche conductrice (231) et chacun desdits deuxièmes moyens de polarisation qui est situé en regard de la zone semiconductrice (220) correspondante, le composant étant **caractérisé en ce que** la couche conductrice (231) recouvre au moins en partie chacune desdites zones semiconductrices (220) .

2. Composant (2) selon la revendication 1, dans lequel la partie de chacune des zones semiconductrices (220) recouverte par la couche conductrice (231) comprend la part de la zone de charge d'espace, formée entre ladite zone semiconductrice (220) et la couche semiconductrice (210), qui se trouve dans la zone semiconductrice (220).

3. Composant (2) selon la revendication 2, dans lequel chacune des zones semiconductrices comporte une concentration en porteurs majoritaires au moins 10 fois supérieure à celle de la couche semiconductrice (210), et dans lequel la couche conductrice (231) recouvre une partie de chacune des zones semiconductrices qui s'étend à partir de la couche semiconductrice sur une dimension d'au moins 0,1 µm, préférentiellement d'au moins 0,2 µm et de manière particulièrement avantageuse d'au moins 0,5 µm.

4. Composant (2) selon l'une quelconque des revendications précédentes, dans lequel le premier moyen de polarisation est adapté pour polariser la portion de la couche semiconductrice (210) en plusieurs emplacements.

5. Composant (2) selon l'une quelconque des revendications précédentes, dans lequel les structures (201) étant destinées à fonctionner dans une gamme de longueurs d'onde donnée, la couche conductrice (231) est réalisée dans un matériau au moins partiellement réfléchissant dans la gamme de longueurs d'onde donnée.

6. Composant (2) selon l'une quelconque des revendications 1 à 5, dans lequel chacun des deuxièmes moyens de polarisation comporte un via conducteur (241) passant par le passage correspondant de la couche conductrice (231) et est en contact électrique avec la zone semiconductrice (220) de la structure (201) qui est associée audit deuxième moyen de polarisation, chacun desdits vias conducteurs (241) étant séparé électriquement de la couche conductrice (231) par un espace isolant (273) qui forme l'espacement.

7. Composant (2) semiconducteur selon l'une quelconque des revendications 1 à 5, dans lequel chacun des deuxièmes moyens de polarisation comporte une zone conductrice (242) dans le même plan que la couche conductrice (231) et un via conducteur (241), ladite zone conductrice (242) étant en contact électrique avec le via conducteur (241) et étant séparée électriquement de la couche conductrice (231) par l'espace isolant (273),
le via conducteurs (241) étant agencés dans la première couche isolante (271), le long de la couche semiconductrice (210), de manière à connecter la structure (201) à laquelle ledit deuxième moyen de polarisation est associé et la zone conductrice (242).

8. Composant (2) selon la revendication précédente, dans lequel, les structures (201) étant destinées à fonctionner dans une gamme de longueurs d'onde donnée, la zone conductrice (242) est réalisée dans un matériau au moins partiellement réfléchissant dans la gamme de longueurs d'onde donnée.

9. Composant (2) selon l'une quelconque des revendications précédentes, dans lequel chacune des structures (201) est une photodiode adaptée pour fonctionner dans la gamme de longueurs d'onde de l'infrarouge et préférentiellement dans une gamme de longueurs d'onde sélectionnée dans le groupe comportant la gamme de longueur d'ondes du proche infrarouge, de l'infrarouge moyen et de l'infrarouge lointain.

10. Composant (2) selon la revendication précédente, dans lequel la couche semiconductrice (210) est réalisée dans un matériau semiconducteur dont la largeur de bande interdite est inférieure à 1,5 eV, le matériau semiconducteur étant préférentiellement du tellurure de mercure-cadmium du type CdₓHg₁₋ₓTe avec x compris entre 1 et 0.

11. Composant (2) selon l'une quelconque des revendications précédentes, dans lequel le composant (2) est adapté pour être couplé avec un dispositif de commande, chacun des deuxièmes moyens de polarisation comportant un plot de connexion (243) adapté pour être connecté à un contact du dispositif de commande, cette connexion étant préférentiellement obtenue par hybridation par billes d'indium.

12. Procédé de fabrication d'un composant (2) semiconducteur selon l'une quelconque des revendications précédentes, comportant les étapes consistant à :
- fournir un support semiconducteur présentant une premier face, ladite première face comprenant au moins une couche semiconductrice d'un premier type de conductivité,
- former une couche électriquement isolante (271) en contact avec la première face du support et s'étendant au moins le long d'une portion de couche semiconductrice (210),
- aménager une pluralité de zones semiconductrices (220) d'un deuxième type de conductivité opposé au premier type de conductivité dans la couche semiconductrice (210), ceci de manière à former une pluralité de structures (201) semiconductrices optoélectroniques comportant chacune l'une des zones semiconductrices (220),
- former dans la couche isolante (271) des percées en communication chacune avec une zone semiconductrice (220),
- former une couche conductrice (231), le matériau conducteur formant la couche conductrice (231) remplissant également lesdites percées,
- former dans la couche conductrice (231) des espaces isolants (273) agencés pour isoler des zones conductrices (242) du reste de la couche conductrice (231), les dites zones conductrices (242) étant chacune en contact avec une percée de manière à former avec le matériau conducteur emplissant la percée un deuxième moyen de polarisation adapté pour polariser la zone semiconductrice (220) correspondante, le reste de la couche conductrice (231) recouvrant au moins en partie chacune des zones semiconductrices (220) et formant un premier moyen de polarisation adapté pour polariser la couche semiconductrice (210), chaque zone conductrice (242) formant avec l'espace isolant (273) l'isolant du reste de la couche conductrice (231) formant un passage dans le reste de la couche conductrice (231).

13. Procédé de fabrication d'un composant (2) semiconducteur selon la revendication précédente, comportant en outre, avant l'étape de formation de la couche conductrice (231), une étape consistant à former des percées en communication chacune avec un emplacement de la portion de la couche semiconductrice (231), lesdites percées étant destinée à former lors de l'étape de formation de la couche conductrice et de leur remplissage par le matériau conducteur, des chemins de conduction (232) adaptés pour polariser la couche semiconductrice (210) auxdits emplacement.

## Patentansprüche

1. Halbleiterbauteil (2), enthaltend:
- einen Halbleiterträger (200, 210) mit einer ersten Fläche und zumindest einer Halbleiterschicht (210) eines ersten Leitfähigkeitstyps, deren Oberfläche die erste Fläche bildet,
- eine Vielzahl von optoelektronischen Halbleiterstrukturen (201), die in einem Abschnitt der Halbleiterschicht (210) angeordnet sind, wobei jede Struktur (201) zumindest einen Halbleiterbereich (220) eines zweiten Leitfähigkeitstyps enthält, der dem ersten Leitfähigkeitstyp entgegengesetzt ist,
- eine elektrisch isolierende Schicht (271), die in Kontakt mit der ersten Fläche des Trägers steht und sich zumindest entlang des Abschnitts der Halbleiterschicht (210) erstreckt,
- ein erstes Vorspannmittel, das dazu geeignet ist, die Halbleiterschicht (210) entlang des Abschnitts der Halbleiterschicht (210) vorzuspannen,
- zweite Vorspannmittel (241, 242), die jeweils einer Halbleiterstruktur (201) zugeordnet sind und jeweils dazu ausgelegt sind, den entsprechenden Halbleiterbereich (220) vorzuspannen,
wobei das erste Vorspannmittel eine leitende Schicht (231) in Kontakt mit der isolierenden Schicht (271) auf derjenigen Fläche der isolierenden Schicht (271) enthält, die dem Träger entgegengesetzt ist und sich entlang des Abschnitts der Halbleiterschicht (210) erstreckt, wobei die leitende Schicht (231) Durchgänge für jedes der zweiten Vorspannmittel in einem dem entsprechenden Halbleiterbereich (220) gegenüberliegenden Abstand zwischen der leitenden Schicht (231) und jedem der zweiten Vorspannmittel aufweist,
wobei das Bauteil **dadurch gekennzeichnet ist, dass**
die leitende Schicht (231) jeden der Halbleiterbereiche (220) zumindest teilweise bedeckt.

2. Bauteil (2) nach Anspruch 1,
wobei der von der leitfähigen Schicht (231) bedeckte Teil jedes der Halbleiterbereiche (220) den Anteil des zwischen dem Halbleiterbereich (220) und der Halbleiterschicht (210) gebildeten Raumladungsbereichs umfasst, der sich im Halbleiterbereich (220) befindet.

3. Bauteil (2) nach Anspruch 2,
wobei jeder der Halbleiterbereiche eine zumindest 10-fach höhere Majoritätsladungsträgerkonzentration aufweist als die Halbleiterschicht (210), und wobei die leitfähige Schicht (231) einen Teil jedes der Halbleiterbereiche bedeckt, der sich ausgehend von der Halbleiterschicht über eine Abmessung von zumindest 0,1 µm, vorzugsweise zumindest 0,2 µm und besonders vorteilhaft zumindest 0,5 µm erstreckt.

4. Bauteil (2) nach einem der vorhergehenden Ansprüche,
wobei das erste Vorspannmittel dazu ausgelegt ist, den Abschnitt der Halbleiterschicht (210) an mehreren Stellen vorzuspannen.

5. Bauteil (2) nach einem der vorhergehenden Ansprüche,
wobei bei Strukturen (201), die in einem gegebenen Wellenlängenbereich betrieben werden sollen, die leitende Schicht (231) aus einem Material hergestellt ist, das in dem gegebenen Wellenlängenbereich zumindest teilweise reflektierend ist.

6. Bauteil (2) nach einem der Ansprüche 1 bis 5,
wobei jedes der zweiten Vorspannmittel eine leitende Durchkontaktierung (241) aufweist, die durch den entsprechenden Durchgang der leitenden Schicht (231) hindurchgeht und in elektrischem Kontakt mit dem Halbleiterbereich (220) der Struktur (201) steht, der das zweite Vorspannmittel zugeordnet ist, wobei jede der leitenden Durchkontaktierungen (241) durch einen isolierenden Zwischenraum (273), der den Abstand bildet, von der leitenden Schicht (231) elektrisch getrennt ist.

7. Halbleiterbauteil (2) nach einem der Ansprüche 1 bis 5,
wobei jedes der zweiten Vorspannmittel einen leitenden Bereich (242) in derselben Ebene wie die leitende Schicht (231) und eine leitende Durchkontaktierung (241) aufweist, wobei der leitende Bereich (242) in elektrischem Kontakt mit der leitenden Durchkontaktierung (241) steht und durch den isolierenden Zwischenraum (273) von der leitenden Schicht (231) elektrisch getrennt ist,
wobei die leitenden Durchkontaktierungen (241) in der ersten isolierenden Schicht (271) entlang der Halbleiterschicht (210) so angeordnet sind, dass sie die Struktur (201), welcher das zweite Vorspannmittel zugeordnet ist, und den leitenden Bereich (242) verbinden.

8. Bauteil (2) nach dem vorhergehenden Anspruch,
wobei bei Strukturen (201), die in einem gegebenen Wellenlängenbereich betrieben werden sollen, der leitende Bereich (242) aus einem Material hergestellt ist, das in dem gegebenen Wellenlängenbereich zumindest teilweise reflektierend ist.

9. Bauteil (2) nach einem der vorhergehenden Ansprüche,
wobei jede der Strukturen (201) eine Photodiode ist, die dazu ausgelegt ist, im infraroten Wellenlängenbereich und vorzugsweise in einem Wellenlängenbereich betrieben zu werden, der ausgewählt ist aus der Gruppe umfassend den Wellenlängenbereich von nahem Infrarot, mittlerem Infrarot und fernem Infrarot.

10. Bauteil (2) nach dem vorhergehenden Anspruch,
wobei die Halbleiterschicht (210) aus einem Halbleitermaterial hergestellt ist, dessen Bandlücke kleiner als 1,5 eV ist, wobei das Halbleitermaterial vorzugsweise Quecksilber-Cadmium-Tellurid vom Typ CdₓHg₁₋ₓTe mit x zwischen 1 und 0 ist.

11. Bauteil (2) nach einem der vorhergehenden Ansprüche,
wobei das Bauteil (2) dazu ausgelegt ist, mit einer Steuervorrichtung gekoppelt zu werden, wobei jedes der zweiten Vorspannmittel ein Verbindungsstück (243) aufweist, das dazu ausgelegt ist, mit einem Kontakt der Steuervorrichtung verbunden zu werden, wobei diese Verbindung vorzugsweise durch Indiumkugelhybridisierung erhalten wird.

12. Verfahren zur Herstellung eines Halbleiterbauteils (2) nach einem der vorhergehenden Ansprüche, umfassend die Schritte:
- Bereitstellen eines Halbleiterträgers mit einer ersten Fläche, wobei die erste Fläche zumindest eine Halbleiterschicht eines ersten Leitfähigkeitstyps enthält,
- Ausbilden einer elektrisch isolierenden Schicht (271) in Kontakt mit der ersten Fläche des Trägers, die sich zumindest entlang eines Abschnitts der Halbleiterschicht (210) erstreckt,
- Anordnen einer Vielzahl von Halbleiterbereichen (220) eines zweiten Leitfähigkeitstyps, der dem ersten Leitfähigkeitstyp entgegengesetzt ist, in der Halbleiterschicht (210), um eine Vielzahl von optoelektronischen Halbleiterstrukturen (201) zu bilden, die jeweils einen der Halbleiterbereiche (220) aufweisen,
- Ausbilden von Durchbrechungen in der isolierenden Schicht (271), die jeweils mit einem Halbleiterbereich (220) in Verbindung stehen,
- Ausbilden einer leitenden Schicht (231), wobei das leitende Material, das die leitende Schicht (231) bildet, auch die Durchbrechungen ausfüllt,
- Ausbilden von isolierenden Zwischenräumen (273) in der leitenden Schicht (231), die dazu angeordnet sind, leitende Bereiche (242) von der restlichen leitenden Schicht (231) zu isolieren, wobei die leitenden Bereiche (242) jeweils in Kontakt mit einer Durchbrechung sind, um mit dem leitenden Material, das die Durchbrechung füllt, ein zweites Vorspannmittel zu bilden, das dazu ausgelegt ist, den entsprechenden Halbleiterbereich (220) vorzuspannen, wobei die restliche leitende Schicht (231) jeden der Halbleiterbereiche (220) zumindest teilweise bedeckt und ein erstes Vorspannungsmittel bildet, das dazu ausgelegt ist, die Halbleiterschicht (210) vorzuspannen, wobei jeder leitende Bereich (242) mit dem isolierenden Zwischenraum (273), der ihn von der restlichen leitenden Schicht (231) isoliert, einen Durchgang in der restlichen leitenden Schicht (231) bildet.

13. Verfahren zum Herstellen eines Halbleiterbauteils (2) nach dem vorhergehenden Anspruch,
ferner umfassend vor dem Schritt des Ausbildens der leitenden Schicht (231) einen Schritt, der darin besteht, Durchbrechungen auszubilden, die jeweils mit einer Stelle des Abschnitts der Halbleiterschicht (231) in Verbindung stehen, wobei die Durchbrechungen dazu bestimmt sind, während des Schritts des Ausbildens der leitenden Schicht und des Füllens mit dem leitenden Material Leitungspfade (232) auszubilden, die dazu ausgelegt sind, die Halbleiterschicht (210) an dieser Stelle vorspannen.

## Claims

1. A semi-conducting component (2) including:
- a semi-conducting support (200, 210) including a first face and at least one semi-conducting layer (210), of a first type of conductivity, the surface of which forms said first face,
- a plurality of optoelectronic semi-conducting structures (201) provided in a portion of the semi-conducting layer (210), each structure (201) including at least one semi-conducting zone (220) of a second type of conductivity opposite the first type of conductivity,
- an electrically insulating layer (271), in contact with the first face of the support and extending at least along the portion of the semi-conducting layer (210),
- a first bias means adapted to bias the semi-conducting layer (210) along the portion of the semi-conducting layer (210),
- second bias means (241, 242) each associated with a semi-conducting structure (201) and each adapted to bias the corresponding semi-conducting zone (220),
the first bias means comprising a conducting layer (231) in contact with the insulating layer (271) on the face of the insulating layer (271) which is opposite the support and which extends along the portion of the semi-conducting layer (210), the conducting layer (231) including passageways for each of the second bias means with a spacing between the conducting layer (231) and each of said second bias means which is located facing the corresponding semi-conducting zone (220),
the component (2) being **characterised in that** the conducting layer (231) covers at least partly each of said semi-conducting zones (220).

2. The component (2) according to claim 1, wherein the part of each of the semi-conducting zones (220) which is covered by the conducting layer (231) comprises the part of the space charge region, formed between said semi-conducting zone (220) and the semi-conducting layer (210), which is in the semi-conducting zone (220).

3. The component (2) according to claim 2, wherein each of the semi-conducting zones includes a concentration of majority carriers at least 10 times higher than that of the semi-conducting layer (210), and wherein the conducting layer (231) covers a part of each of the semi-conducting zones which extends from the semi-conducting layer on a dimension of at least 0.1µm, preferentially at least 0.2µm and particularly advantageously at least 0.5µm.

4. The component (2) according to any of the preceding claims, wherein the first bias means is adapted to bias the portion of the semi-conducting layer (210) in several locations.

5. The component (2) according to any of the preceding claims, wherein the structures (201) being intended to operate in a given wavelength range, the conducting layer (231) is made of a material at least partly reflecting in the given wavelength range.

6. The component (2) according to any of claims 1 to 5, wherein each of said second bias means includes a conducting via (241) passing through the corresponding passageway of the conducting layer (231) and is in electrical contact with the semi-conducting zone (220) of the structure (201) which is associated with said second bias means, each of said conducting vias (241) being electrically separated from the conducting layer (231) by an insulating space (273) which forms the spacing.

7. The semi-conducting component (2) according to the preceding claim, wherein each of the second bias means further includes a conducting zone (242) in the same plane as the conducting layer (231), said conducting zone (242) being in electrical contact with the conducting via (241) and being electrically separated from the conducting layer (231) by the insulating space (273),
the conducting via being arranged in the electrically insulating layer (271), along the first semi-conducting layer (210), in such a way to connect the structure (201) at which said second bias means is associated and the conducting zone (242).

8. The component (2) according to the preceding claim, wherein the structures (201) being intended to operate in a given wavelength range, the conducting zone (242) is made of a material at least partly reflecting in the given wavelength range.

9. The component (2) according to any of the preceding claims, wherein each of the structures (201) is a photodiode adapted to operate in the infrared wavelength range and preferentially in a wavelength range selected in the group including the near infrared, medium infrared and far infrared wavelength range.

10. The component (2) according to the preceding claim, wherein the semi-conducting layer (210) is made of a semi-conductor material the energy band gap of which is lower than 1.5eV, the semi-conductor material being preferentially CdₓHg₁₋ₓTe type mercury-cadmium telluride with x between 1 and 0.

11. The component (2) according to any of the preceding claims, wherein the component (2) is adapted to be coupled with a controlling device, each of said second bias means including a connecting pad (243) adapted to be connected to a contact of the controlling device, this connection being preferentially achieved by indium ball hybridization.

12. A method for manufacturing a semi-conducting component (2) according to any of the preceding claims, comprising the steps of:
- providing a semi-conducting support having a first face, said first face comprising at least one semi-conducting layer of a first type of conductivity,
- forming an electrically insulating layer (271) in contact with the first face of the support and extending at least along a portion of the semi-conducting layer (210),
- providing a plurality of semi-conducting zones (220) of a second type of conductivity opposite the first type of conductivity in the semi-conducting layer (210), so as to form a plurality of optoelectronic semi-conducting structures (201) each including one of the semi-conducting zones (220),
- forming in the insulating layer (271) holes each in communication with a semi-conducting zone (220),
- forming a conducting layer (231), the conducting material forming the conducting layer (231) also filling said holes,
- forming in the conducting layer (231) insulating spaces (273) arranged to insulate conducting zones (242) from the rest of the conducting layer (231), said conducting zones (242) being each in contact with a hole so as to form with the conducting material filling the hole a second bias means adapted to bias the corresponding semi-conducting zone (220), the rest of the conducting layer (231) covering at least partly each of the semi-conducting zones (220) and forming a first bias means adapted to bias the semi-conducting layer (210), each conducting zone (242) forming with the insulating space (237) the insulator from the rest of the conducting layer (231) forming a passageway in the rest of the conducting layer (231).

13. The method for manufacturing a semi-conducting component (2) according to the preceding claim, further including, before the step of forming the conducting layer (231), a step of forming holes each in communication with a location of the portion of the semi-conducting layer (231), said holes being intended to form during the step of forming the conducting layer and filling them with the conducting material, conducting paths (232) adapted to bias the semi-conducting layer (210) at said locations.
